# EUROPEAN PATENT APPLICATION

(11) **EP 1 054 346 A2**
(43) Date of publication of application: **22.11.2000**
(21) Application number: 00304121.7
(22) Date of filing: 16.05.2000
(51) Int. Cl.: G06K 19/077

(54) **Non-contact chip card comprising a pair of covering sheets**

(30) Priority: 21.05.1999 JP 14177299
(71) Applicant: SHINKO ELECTRIC INDUSTRIES CO. LTD., Nagano-shi, Nagano 380-0921 (JP)
(72) Inventor: Akagawa, Masatoshi c/o Shinko Electric Ind. Co.Ltd, Nagano-shi, Nagano 380-0921 (JP)
(74) Representative: Rackham, Stephen Neil

(57) **Abstract**

A non-contact type IC card comprises a core-sheet (12), made of resin, having first and second surfaces and a hole (14) penetrating from the first surface to the second surface; a plane coil (54) formed on the first surface of the core-sheet, the plane coil having respective terminals (54a, 54b) located at an opening region in the hole; a semiconductor element accommodated (56) in the hole, the semiconductor element having electrodes terminals (58) electrically connected to the respective terminals of the plane coil; and a pair of over-sheets (62), made of resin, for covering the first and second surfaces, respectively, to integrally cover the core-sheet with the plane coil and the semiconductor element.

## Description

The present invention relates to a non-contact type IC card composed in such a manner that over-sheets are attached onto the respective faces of a core-sheet to which a semiconductor element and a plane coil are attached.

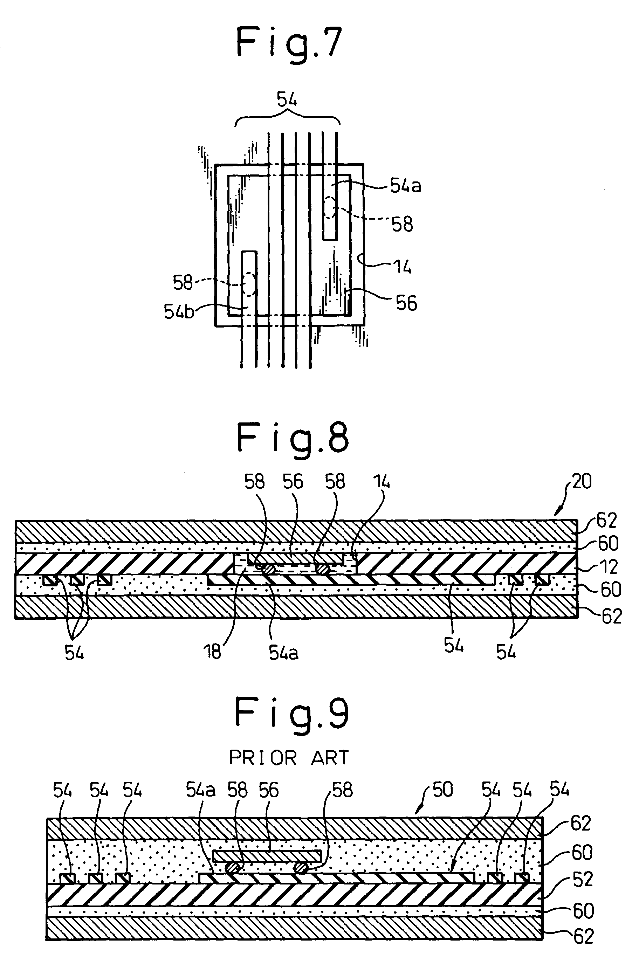

Referring to Fig. 9, an overall arrangement of a conventional non-contact type IC card 50 will be explained below.

The core sheet 52 is made of polyimide resin.

The plane coil 54 is formed on one face of the core sheet 52. The semiconductor element 56 is mounted on one face of the core sheet 52 so that the face of the semiconductor element 56 on which the electrode terminals 58 are formed, that is, the electrode terminal formation face of the semiconductor element 56 can be opposed to one face of the core sheet 52. The electrode terminals 58 are electrically connected with the respective terminal sections 54a, 54b (54b is not shown in the drawing) of the plane coil 54.

The over-sheets 62, on one face of each of which an adhesive sheet 60 is formed, are attached onto the respective faces of the core sheet 52. These over-sheets 62 and core sheet 52 are subjected to thermal pressing, so that they are integrally heated, pressed and formed into a single body.

However, the following problems occur in the above mentioned conventional non-contact type IC card. Since the semiconductor element 56 is mounted on the surface of the core sheet 52 and further the over-sheet 62 is put on the semiconductor element 56, the thickness of the non-contact type IC card is increased. Further, irregularities are caused on the surface of the non-contact type IC card 50 by the semiconductor element 56 mounted on the surface of the core sheet 52.

Furthermore, since the core sheet 52 is made of expensive polyimide resin, the unit price of the non-contact type IC card 50 is high.

The present invention is intended to solve the above problems. Accordingly, it is an object of the present invention to provide a non-contact type IC card which is thin and in which irregularities are seldom caused on the surface of non-contact type IC card.

According to the present invention, there is provided a non-contact type IC card comprising: a core sheet made of resin and having first and second surfaces and a through-hole penetrating from the first surface to the second surface; a plane coil formed on the first surface of the core sheet, the plane coil having respective terminals located at a region in the hole; a semiconductor element accommodated in the hole, the semiconductor element having electrodes terminals electrically connected to the respective terminals of the plane coil; and a pair of over sheets, made of resin, for covering the first and second surfaces, respectively, to integrally cover the core sheet with the plane coil and the semiconductor element.

Due to the above arrangement, the semiconductor element is accommodated or housed in the through-hole formed on the core-sheet. Therefore, the thickness of the non-contact type IC card can be reduced, and irregularities are seldom-caused on the surface of the non-contact type IC card.

If the resin material is changed from polyimide resin to polyethylene resin which is less expensive than polyimide resin, the unit price of the product can be lowered.

If the through-hole is filled with sealing material, the semiconductor element can be mechanically reinforced. Therefore, the mechanical strength of the non-contact type semiconductor element can be enhanced when a bending force or an impact is given to the non-contact type semiconductor element.

The respective terminals can be transversely extending along the first surface of the core sheet over an opening of the hole. Otherwise, respective terminals can be extending into and terminated at the opening region of the hole.

A thickness of the semiconductor element may be substantially the same or a little smaller than that of the core sheet, so that the semiconductor element can thus be accommodated in the hole within a range of thickness of the core sheet.

Referring to the appended drawings, preferred embodiments of the non-contact type IC card of the present invention will be explained with reference to the accompanying drawings; in which:-
Figs. 1 to 4 are schematic illustrations for explaining a manufacturing process of an embodiment of the non-contact type IC card of the present invention;
Fig. 5 is a plan view for explaining a positional relation between the plane coil and the thorough-hole of the non-contact type IC card shown in Fig. 1;
Fig. 6 is an enlarged view showing a portion close to the through-hole illustrated in Fig. 5;
Fig. 7 is an enlarged view showing a portion close to the through-hole of the non-contact type IC card in which both terminal sections of the plane coil protrude into the through-hole;
Fig. 8 is a schematic illustration for explaining another embodiment of the non-contact type IC card of the present invention; and
Fig. 9 is a schematic illustration for explaining an example of the structure of a conventional non-contact type IC card known in the prior art.

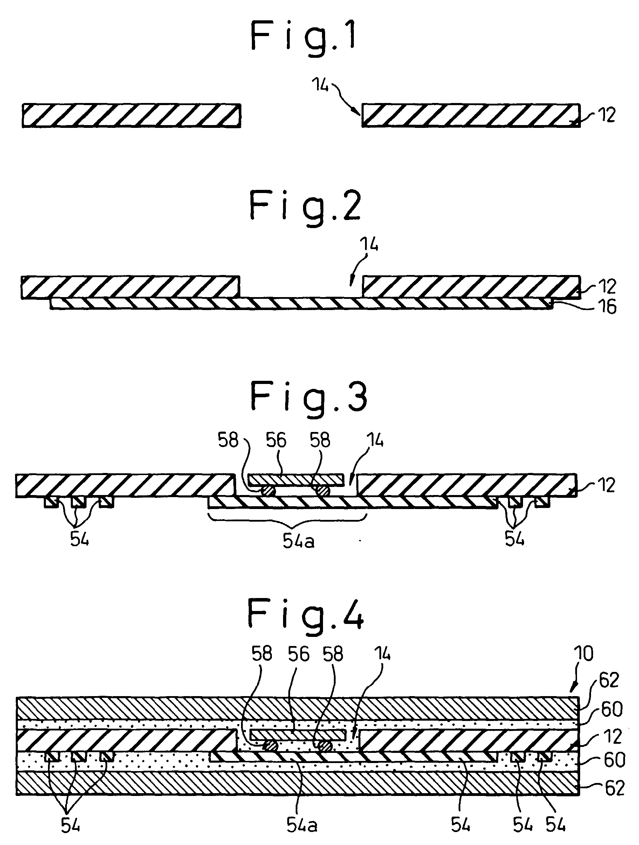

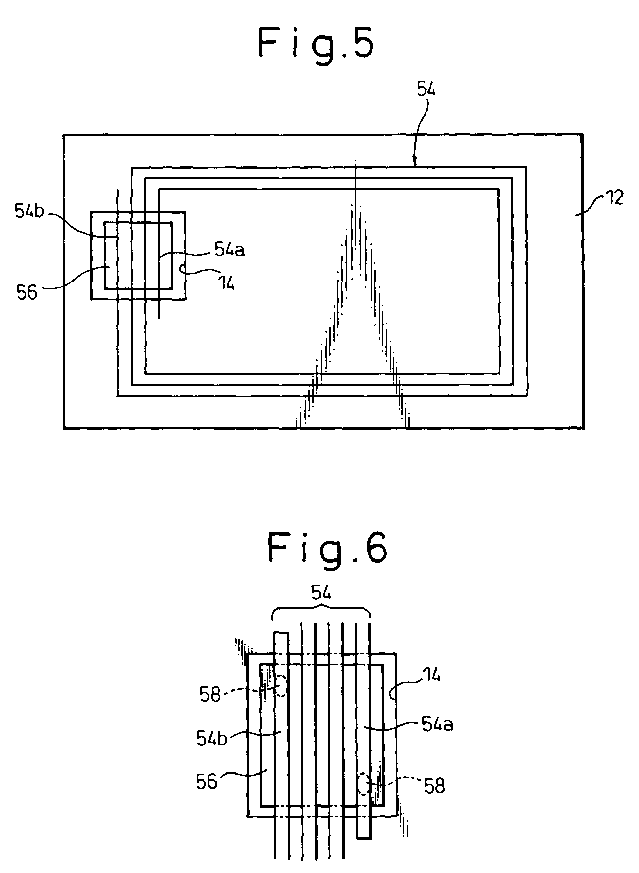

First, referring to Figs. 4 and 5, the structure of the non-contact type IC card 10 is explained below. In this connection, like reference characters are used to indicate like parts in these views and the view showing the conventional example, and detailed explanations are omitted here.

The core sheet 12 is made of resin material, and the through-hole 14 is formed in the core sheet 12 so as to penetrate from the upper surface to the lower surface of the IC card. In this case, when the core sheet 12 is made of polyethylene resin, such as PET, which is less expensive than polyimide resin, the manufacturing cost of the non-contact type IC card 10 can be preferably reduced.

The plane coil 54 is formed on one face of the core sheet 12, that is, the plane coil 54 is formed on a lower face of the core sheet 12 as shown in Fig. 4. The plane coil 54 is made of metal such as aluminum or copper, and both terminal sections 54a, 54b of the plane coil 54 are arranged in the through-hole 14. To be more specific, in this embodiment, the terminal sections 54a, 54b of the plane coil 54 are arranged over the through-hole 14, and at least portions of the terminal sections 54a, 54b with which the electrode terminals 58 of the semiconductor element 56 are connected are plated with gold.

The semiconductor element 56 is housed in the through-hole 14 from the other face side (the upper face side shown in Fig. 4) of the core sheet 12 so that the face on which the electrode terminals 58 are formed, that is, the electrode terminal formation face can be directed onto the plane coil 54 side, and a pair of electrode terminals 58 are electrically connected with the terminal sections 54a, 54b of the plane coil 54 by means of ultrasonic bonding.

In this case, when a thin semiconductor element 56, the thickness of which is approximately 50 µ, is used, the semiconductor element 56 does not protrude from the surface of the commonly used core sheet 12 made of PET, the thickness of which is approximately 75 µ. Therefore, no protruding portion are formed on the surface of the non-contact type IC card 10. Further the thickness of the non-contact type IC card 10 can be reduced. In this connection, in order to prevent the occurrence of irregularities, it is preferable that the thickness of the core sheet 12 and that of the semiconductor element 56 (the thickness of the semiconductor element 56 including the electrode terminals 58) are made equal to each other.

On both faces of the core sheet 12, in the through-hole 14 of which the semiconductor element 56 is housed, a pair of over-sheets 62 made of resin, on one face of each of which an adhesive layer 60 is formed, are respectively arranged in such a manner that the adhesive layer 60 is located on the core sheet 12 side. These over-sheets 62 are integrated with the core sheet 12 when they are heated and pressed by means of thermal press. In the same manner as that of the core sheet 12, it is preferable that the over-sheets 62 are made of polyethylene resin which is less expensive than polyimide resin.

Next, referring to Figs. 1 to 4, the manufacturing process of the non-contact type IC card 10 will be explained below.

In the first process, the through-hole 14 is formed on the core sheet 12 as shown in Fig. 1. In this connection, the profile and size of the through-hole 14 are determined so that the semiconductor element 56 can be housed in the through-hole 14 while consideration is given to the profile of the semiconductor element 56. In order to prevent the formation of irregularities on the surface of the non-contact type IC card, the thickness of the core sheet 12 is determined by giving consideration to the thickness of the semiconductor element 56, that is, it is preferable that the thickness of the core sheet 12 is the same as the thickness of the semiconductor element 56.

In the second process, a layer of foil 16 of metal such as copper or aluminum is made to adhere onto one face of the core sheet 12, that is, a layer of foil 16 of metal such as copper or aluminum is made to adhere onto a lower face shown in Fig. 1 as illustrated in Fig. 2.

In the third process, the layer of metallic foil 16 is etched in a predetermined pattern, so that the plane coil 54 is formed on one face of the core sheet 12. An example of the plan profile of the plane coil 54 is shown in Fig. 5. The plane coil 54 is arranged so that a portion of the plane coil 54 can be arranged over the through-hole 14. Especially, in the case of the plane coil 54 of this embodiment, as shown in Fig. 6, the terminal sections 54a, 54b are also arranged over the through-hole 14. However, it is possible to adopt such a structure that the terminal sections 54a, 54b are not arranged over the through-hole 14 but are extended into the through-hole 14 as shown in Fig. 7. If necessary, the terminal sections 54a, 54b may be plated with gold.

In the fourth process, the semiconductor element 56 is housed in the through-hole 14 in such a manner that the electrode terminal forming face is directed to the plane coil 54 side as shown in Fig. 3. In this case, the semiconductor element 56 is housed in the through-hole 14 while the semiconductor element 56 is being positioned so that a pair of electrode terminals 58 formed on the electrode terminal face can be contacted with the terminal sections 54a, 54b of the plane coil 54. The electrode terminals 58 of the semiconductor element 56 are electrically connected with the terminal sections 54a, 54b of the plane coil 54 by means of ultrasonic bonding.

In the fifth process, the over-sheets 62 made of polyethylene resin, on only one face of which the adhesive layer 60 is formed, are made to adhere onto both faces of the core sheet 12, in the through-hole 14 of which the semiconductor element 56 is housed. These over-sheets 62 are integrated with both faces of the core sheet 12 when they are heated and pressed by means of thermal press as shown in Fig. 4. In this way, the non-contact type IC card illustrated in Fig. 4 can be manufactured.

When a process in which the sealing material is filled in the through-hole 14 is provided between the fourth and the fifth process, it becomes possible to manufacture the non-contact type IC card 20 in which the periphery of the semiconductor element 56 is reinforced by the sealing material 18 as shown in Fig. 8.

## Claims

1. A non-contact type IC card comprising:
a core-sheet, made of resin, having first and second surfaces and a through-hole penetrating from said first surface to said second surface;
a plane coil formed on said first surface of the core-sheet, said plane coil having respective terminals located at an opening region in said through-hole;
a semiconductor element accommodated in said hole, said semiconductor element having electrodes terminals electrically connected to said respective terminals of the plane coil;
a pair of over-sheets, made of resin, for covering said first and second surfaces, respectively, to integrally cover said core-sheet with said plane coil and said semiconductor element.

2. An IC card as set forth in claim 1, wherein said core-sheet is made of polyethylene resin.

3. An IC card as set forth in claim 1 or 2, wherein said over-sheets are made of polyethylene resin.

4. An IC card as set forth in any one of the preceding claims, wherein said hole is filled with a sealing material.

5. An IC card as set forth in claim 1, wherein said respective terminals are transversely extended along said first surface of the core sheet and over an opening of said through-hole.

6. An IC card as set forth in any one of the preceding claims, wherein said respective terminals are extending into and terminated at said opening region of the through-hole.

7. An IC card as set forth in any one of the preceding claims, wherein the thickness of said semiconductor element is substantially the same as, or a little smaller than, that of said core sheet, so that said semiconductor element is accommodated in said through-hole within the thickness of said core-sheet.
